# EUROPEAN PATENT APPLICATION

(11) **EP 4 622 400 A1**
(43) Date of publication of application: **24.09.2025**
(21) Application number: 25158448.8
(22) Date of filing: 18.02.2025
(51) Int. Cl.: H05K 1/02, H05K 3/00, H05K 1/03, H05K 3/46

(54) **COMPONENT CARRIERAND MANUFACTURING METHOD**

(30) Priority: 19.03.2024 CN 202410315811
(71) Applicant: AT & S Austria Technologie & Systemtechnik Aktiengesellschaft, 8700 Leoben-Hinterberg (AT)
(72) Inventor: PARK, Ho Sik, Chongqing, 401120 (CN); MOK, Jee Soo, 8700 Leoben (AT)
(74) Representative: Donatello, Daniele

(57) **Abstract**

The present application provides a component carrier (100) with a stack (102) and manufacturing method thereof, wherein said stack (102) comprises:
i) at least one electrically insulating layer structure (106) and at least one electrically conductive layer structure (104);
ii) a stack side wall (107), wherein at least a portion (110) thereof is tapered with respect to a stacking direction (Z); and
iii) at least one inorganic layer structure (108), said inorganic layer structure (108) being laterally exposed and forming at least partially said stack side wall (107).

## Description

### Field of the Invention

The invention relates to a component carrier with a stack that comprises at least one electrically insulating layer structure and at least one electrically conductive layer structure. The stack further comprises a stack side wall, wherein at least a portion thereof is tapered with respect to a stacking direction. The stack further comprises at least one inorganic layer structure, which is laterally exposed and forming at least partially said stack side wall. Further, the invention relates to a method of manufacturing said component carrier. Additionally, the invention relates to a method of manufacturing said component carrier by separating a component carrier preform into a plurality of component carriers.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

In particular, forming efficient and reliable stacks with respect to a component carrier, when using an inorganic layer structure, may still be considered a challenge. Such inorganic layer structure have become more and more interesting from a technical and economical point of view. For example, a glass layer structure (glass core) may provide specific advantageous thermal properties. Since glass is not that sensitive to heat, it is not likely to change with heat, therefore there is almost no shrinkage on the glass.

Component carriers such as printed circuit boards are generally manufactured as parts of component carrier preforms (so-called panels), wherein a plurality of component carriers are manufactured (e.g. laminated) at the same time. After said process, the component carrier preform is separated (also known as singularization, cutting dicing) into a plurality of single component carriers.

However, an inorganic layer structure (in particular glass) as described above may still be considered a challenge in such a separation process.

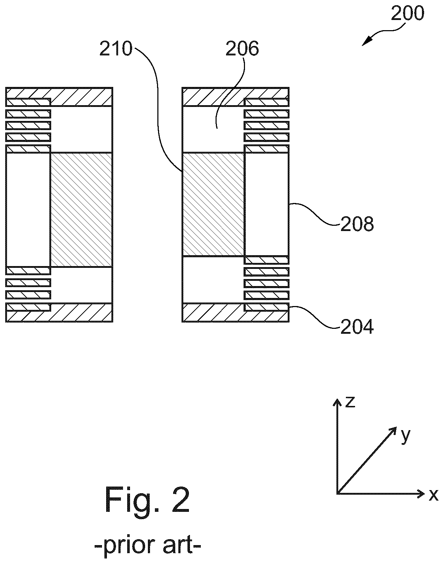

**Figure 2** shows a schematic cross-section through two single component carriers 200 after separation according to the prior-art. Each component carrier 200 has electrically insulating layer structures 206 and an electrically conductive layer structure 204 provided between electrically insulating layer structures 206. The inorganic layer structure 208 is arranged sandwiched between the electrically insulating layer structures 206 and at least two of the electrically conductive layer structures 204 and forms a core layer. The stack side walls are straight with each other in the stacking direction Z. Separation has been done for example by a cutting/drilling process. It can be seen that at said stack side wall, the inorganic layer structure 208 is not exposed. Instead, another material 210, e.g. a resin, is provided. This other material 210 provides additional costs and efforts but is necessary, however, to avoid cracks in the inorganic layer structure 208 during the separation process.

Current stacks formed using conventional technology may be prone to dielectric material degradation, delamination and difficulties mitigating glass damage, especially cracks. There is a constant trend in the industry towards smaller structures on the one hand and higher signal rates/frequencies on the other hand. Thus, the quality and performance of the formed stacks, in particular of an inorganic layer structure, of a component carrier may be crucial.

### Summary of the Invention

There may be a need to provide a component carrier with an inorganic layer structure in an efficient and robust manner.

A component carrier and manufacturing methods are described.

According to an aspect of the invention, a component carrier with a stack is provided, wherein said stack comprises:
i) at least one electrically insulating layer structure;
ii) at least one electrically conductive layer structure;
iii) a stack side wall (lateral wall), wherein at least a portion thereof (e.g. a portion of an insulating/conductive layer structure and/or the inorganic layer structure) is tapered with respect to a stacking direction (stacking thickness direction, along Z); and
iv) at least one inorganic layer structure (e.g. a glass core), said inorganic layer structure being laterally exposed and forming at least partially said stack side wall.

According to another aspect of the invention, a method of manufacturing a component carrier is provided, wherein the method comprises:
i) providing a stack with at least one electrically insulating layer structure and at least one electrically conductive layer structure;
ii) providing a stack side wall to the stack (during a separation process), wherein at least a portion thereof is tapered with respect to the stacking direction (in particular caused by laser drilling); and
iii) providing at least one inorganic layer structure to the stack, wherein said inorganic layer structure is formed to be laterally exposed and forms at least partially said stack side wall (in particular also separated by the laser drilling process).

According to a further aspect of the invention, there is described a method of manufacturing a component carrier, the method comprising:
providing a component carrier preform (e.g. a panel);
separating the component carrier preform into a plurality of component carriers,
wherein there is provided at least one component carrier as described above and/or wherein the method as described above is performed.

In the present context, the term "component carrier" may refer to a final component carrier product. The term "component carrier preform" may refer to a component carrier in production, in other words a semi-finished product. In an example, a component carrier preform may be a panel that comprises a plurality of semi-finished component carriers that are manufactured together. At a final stage, the panel may be separated into the plurality of final component carrier products by separating/cutting/dicing.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier. In an example, all layers of the component carrier may form the stack. In another example, only a part of the layers of the component carrier form the stack.

In this context, the term "side wall" may in particular refer to a lateral delimitation of a stack. The lateral delimitation may also comprise a boundary of a stack, in particular a laterally exposed boundary of a stack. The lateral delimitation of a stack can also comprise a boundary which is not laterally exposed, in particular a boundary formed adjacently to, preferably abutting another material. In particular, the term "stack side wall" can also include a (glass) substrate edge structure and/or stack build-up layer (portion) edge structures.

In this context, the term "layer structure" may in particular refer to a continuous or discontinuous layer (or separated islands within the same plane) of electrically conductive and/or electrically insulating material. A plurality of such layers, parallel stacked one upon the other, may form the stack in the vertical direction.

In the context of the present document, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass or quartz. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

According to an exemplary embodiment, the invention may be based on the idea that a component carrier with an inorganic layer structure may be provided/manufactured in a (cost-) efficient and robust (stable)manner, when at least a portion of a stack side wall is tapered with respect to a stacking direction and the inorganic layer structure is laterally exposed (compare Figure 2 of the prior art) and forming at least partially said stack side wall.

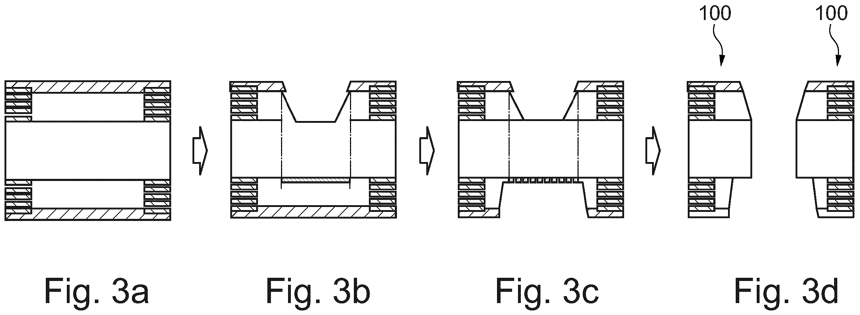

The described specific architecture of the component carrier sidewall reflects an especially advantageous manufacture process that applies laser cutting from two different sides (from above and from below) of the panel under production. As is described for example regarding Figure 3 in detail, a plurality of different approaches are possible, depending on the desired application. For example, laser cutting may be done in the first place only through the stack build-up layers, and afterwards through the inorganic layer structure (core layer).

It has been surprisingly found by the inventors that such an approach may enable an efficient and reliable cutting process for a component carrier stack that comprises an inorganic layer structure as such an approach can change the high stress point from the centre of inorganic layer structure to the interface between the inorganic layer structure and the electrically insulating layer structure, therefore the stress inside of the inorganic layer structure is lower, and then the risk of the crack of inorganic layer structure, in particular the horizontal crack inside of the inorganic layer structure, may be significantly reduced after singulation of the component carrier (such as at the process of dicing, routing, laser drilling).

Meanwhile, this approach can also reduce the stress of interface to mitigate the risk of the crack from the interface and/or surface of inorganic structure. Additionally this approach and product structure may also reduce the risk of delamination between the electrically insulating structure and the inorganic layer structure. Meanwhile it may provide the important advantage of reducing the saw street distance (the width of cutting can be reduced from 250-300 µm to less than 100 µm), therefore there may be no need for additional fiducial design applied for cutting.

Conventionally, cracking of the inorganic layer structure during separation had to be accepted or costly additional protection material had to be provided (see e.g. Figure 2). However, with the approach present here, efficient cutting may be enabled, resulting in a stack lateral side wall that is (at least partially) tapered and comprises the exposed inorganic layer structure.

The described approach may be implemented into existing production lines in a straightforward manner.

### Exemplary Embodiments

Generally, it is known for a person at skilled of the art that CTE mismatch could cause inner stress of materials. There may be a big CTE mismatch in the component carrier stack comprising inorganic material and organic material, in particular the CTE mismatch (the mismatch gap can be minimum 15 ppm) is generated between the inorganic layer structure and the electrically insulating layer structure. When the heat treatment is applied to the inorganic layer structure and electrically insulating layer structure, the electrically insulating layer structure is prone to shrink, but the inorganic layer structure is much more stable; therefore the stress is generated and accumulated in the inorganic material. Beside that the cutting also cause stress due to the mechanical strength.

In an embodiment, the tapered portion of the stack side wall comprises or consists of the exposed portion of the inorganic layer structure. By tapering the stack side wall comprising the exposed portion of the inorganic layer structure, the lateral extent of the inorganic layer structure can be reduced in the direction of the interface between the inorganic layer structure and the electrically insulating layer structure. This may bring the advantage of reducing stress of the inorganic material and changing the high stress point to the interface between the inorganic layer structure and the electrically insulating layer structure.

In an embodiment, the tapered portion of the stack side wall comprises two sub portions arranged adjacent to each other, wherein the surface of each sub portion is tapered, in particular wherein the surfaces taper away from each other. The sub portions can, in particular, meet at the point of the greatest lateral extent of the stack side wall. With the surfaces tapering away from each other, the lateral extent of the stack side wall can especially be reduced in the direction of the interface between the inorganic layer structure and the electrically insulating layer structure. The reduction of stress in the inorganic layer structure resulting from the high stress point change to the interfaces between the respective sub portions between the inorganic layer structure and the electrically insulating layer structure can therefore be achieved. This may bring the advantage of mitigating glass substrate horizontal crack after dicing.

With the structure of component carrier by the cutting method the high stress point changed to the interface between the inorganic layer structure and the electrically insulating layer structure of stack, it won't cause the crack from inside of the inorganic layer structure. Furthermore, the cutting method could also decrease the stress accumulated on the said interface, that means the damage on the interface might be avoided, in particular when the cutting method is applied by laser ablation. Even when there is damage on the interface, there should be no harm on the whole product since it is only for singulation, and the damaged area is inactive area. Moreover, the damage should be minor, and it can be mitigated by other method for final package. Additionally, the high stress point from inner of inorganic layer structure changes to two interface of front side surface to back side surface, the accumulated stress may be distributed and divided to the two points.

In an embodiment, a lateral extension profile of the inorganic layer structure follows the stack thickness direction. In other words, the lateral extension profile of the inorganic layer structure does not taper as the profile is parallel to the stack thickness direction. In particular, the sidewall of the inorganic layer structure can be vertically straight. This embodiment may also enable the sidewall to be flush at the interface with the electrically insulating layer structure. On the other hand, it may also be advantageous to have the sidewall to be offset at the interface with the electrically insulating layer structure. In particular, the lateral extent of the inorganic layer structure may be larger or smaller than the lateral extent of the electrically insulating layer structure. This may bring the advantage of having characteristics exhibiting a homogenous lateral extent of the inorganic layer structure. This can for example contribute to a more homogenous propagation of electromagnetic signals at a sidewall interface. With such kind of structure and approach for cutting, it represents the accuracy and wide process cutting window or a big tolerance of the cutting process can be achieved, in particular the laser ablation can achieve the accuracy of 1 µm cutting width and the whole cutting tolerance can be to 250 µm, which cannot be realized by conventional approach and structure.

In an embodiment, the tapered portion is formed at least partially on at least one of the layer structures of the stack. In other words, there can be also no taper for the stack which is straight and there can be a taper on one side of the stack and another side of the stack with a straight sidewall. This may bring the advantage of having a stack with heterogeneous tapering characteristics with one side of the stack with a taper and reducing a high stress point change at an interface between the inorganic layer structure and the electrically insulating layer structure and on the other hand also preserving a side of the stack with a homogenous lateral extent. One can therefore obtain a more targeted characteristic of different technical advantages within a stack. This approach and product structure brings a lot of flexibility to secure the quality of singulation of the component carrier with inorganic material considering the fragile property of inorganic material which is prone to crack (such as glass).

In an embodiment, the tapered portion is defined by a plurality of layer structures of the stack. In other words, it is possible to have a mix of inorganic layer structures, electrically conductive layer structures and electrically insulating layer structures. This may bring the advantage of tailoring the specific needs of a stack having different amounts of various layer structures. This means the tapered portion can be aligned or misaligned. With this structure, there can be no crack in the inorganic layer structures and no delamination between the inorganic layer structures and the stack with electrically conductive layer structures and electrically insulating layer structures. Further, there may be no damage area on at least one of the surface of the inorganic material caused by cutting, in particular by the laser ablation which cause the thermal and laser energy transmitted from one surface of inorganic layer structure to the opposite surface of the inorganic layer structure due to the transparency of the inorganic layer structures.

In an embodiment, the at least one electrically insulating layer structure, that defines the tapered portion, is different from the at least one inorganic layer structure, in particular wherein said at least one electrically insulating layer structure comprises an organic material. In other words, the electrically insulating layer can comprise an organic material like epoxy-based build-up material or polymer compounds whereas the inorganic layer structure can comprise of a material made up of glass or quartz. This may bring the advantage of having both inorganic and organic materials to make up the stack, integrating both organics and inorganics in a stack. This can provide requisite functions of an electrical material and facilitate formation. This can provide for superior insulating properties and also superior processing characteristics. Advantageous characteristics can therefore be selectively used.

Furthermore, the mix of the inorganic material and organic material to design and produce the component carrier may have an important advantage from perspectives of the product function and manufacturing as the inorganic material is very flat with thermal stability with which means the fine line structuring and less shrinkage can be achieved. This is very beneficial for high performance computing.

Additionally the inorganic material also has good performance from electrical point of view. However the organic material is conventionally being dielectric layer in the component carrier with good dielectric property, but it is sensitive to thermal treatment which means it is likely to get warpage and shrinkage. Combination of inorganic material and organic material can take the advantage of inorganic material and organic material and compensate the disadvantage of the two materials to get balance from production and product function. Nevertheless there are still some drawbacks which cannot be overcome such as the CTE mismatch between the two material and the brittleness of inorganic material in some process. Therefore, the invention provide a component carrier with tapered portion at different areas in the product to mitigate the problems resulting from the CTE mismatch and brittleness of the inorganic material, even compensate the shrinkage of the organic material, which finally obtain a good single unit of product after cutting for singluation from different tools.

In an embodiment, the tapered portion is defined only, in particular exclusively, by electrically insulating layer structures. In other words, the stack can be formed absent of electrically conductive layer structures. This may bring the advantage of forming a stack with superior insulating properties depending on the specific application which this embodiment enables. Additionally it may bring the advantage of simple manufacturing process and less cost with good efficiency.

In an embodiment, the inorganic layer structure comprises a lateral extension being different from the other layer structures of the stack wherein said lateral extension forms at least one protrusion at said stack side wall. In other words, the protrusion can have a lateral extension greater than the surrounding layer structure. In particular, the vertical extent of the protrusion within a layer structure is equal to or smaller than the total thickness of the layer structure. The protrusion can be of a similar material compared to the surrounding layer structure and also be of a different material compared to the surrounding layer structure. This means that the protrusion can also be part of an interface between the layer structure in which it is made of and the surrounding layer structure of a different composition. This may bring the advantage of reducing stresses even within a layer structure which may comprise of a homogeneous material composition.

More importance is that such kind of structure and approach brings different cutting edges in one component carrier. It does not only change the high stress point from the inner of the inorganic layer structure to the interface between the inorganic layer structure and the electrically insulating layer structure, which significantly help reduce the stress inside of the inorganic layer structure caused by the CTE mismatch, but also eliminate the stress from the mechanical strength by cutting through the component carrier at one time from top to bottom (by the tool such as routing, dicing, laser drilling, etc.).

In an embodiment, the protrusion forms at least one step at the edge of said inorganic layer structure. In other words, the protrusion can also form multiple steps at the edge of the inorganic layer structure enabling the inorganic layer structure to have characteristics of a stepped structure. This may bring the advantage of a stepwise stress reduction especially for situations where higher manufacturing tolerances are required. This may in particular, lead to a more uniformly distributed stress reduction profile at the edge of the inorganic layer structure. Further, it provides the solution to remove the damage of the opposite surface caused by the heat and energy of laser ablation which transmit from the other surface due to the transparency of inorganic material, in particular for the glass.

In an embodiment, the stack side wall comprises at least two tapered portions, wherein said tapered portions are arranged, in particular adjacently, along a stack thickness direction (Z). The stack side wall can comprise of multiple tapered portions which can be arranged in such a way that a non-tapered layer structure can be sandwiched between two tapered portions. Preferably, the tapered portions are arranged adjacently to each other. This may bring the advantage of tailoring a stress profile with variations in a two-dimensional (2D) stress profile tailoring that may comprise measures of advanced mitigation of cracks for high precision manufacturing.

In an embodiment, the tapered portions are continuously or in-continuously provided one along the other along the stack thickness direction (Z). In other words, in an in-continuous stack variation, the stack can comprise a tapered portion followed by a straight or non-tapered portion before a further tapered portion is formed at the interface of the straight portion. In a continuous stack composition, the tapered portions can be tapered in a same or different direction. This may bring the advantage of enabling multiple profile variations along the stack thickness direction. This can also enable profile variations in a two-dimensional (2D) or three-dimensional (3D) of the stack side wall. Such a high flexibility could save a lot of additional investment cost for inorganic component manufacturing. It can be realized by normal component manufacturing process.

In an embodiment, the at least two tapered portions are distanced to each other by at least one of the layer structures of the stack. In other words, at least two tapered portions are arranged in such a way that they are non-adjacent to each other and a different layer structure, for example, an electrically insulating or an inorganic layer structure can be arranged between two tapered portions. This may bring the advantage of a stack exhibiting better mechanical characteristics or properties and enable a more specific tailoring of requirements to suit particular manufacturing needs.

In an embodiment, the at least two tapered portions taper in the same direction or in opposed directions. In other words, the two tapered portions can form an arrow-like shape when viewed in a lateral direction or an inverted arrow-like shape when viewed in a lateral direction when at least two tapered portions taper in opposing directions. This may bring the advantage of reducing stress at interfaces when desired or even an increase in stress in a vertical direction when so required.

In an embodiment, a first portion (a first layer-build up) of the stack is provided on a first main surface of the inorganic layer structure; and a second portion (a second layer build-up) of the of the stack is provided on a second main surface, being opposed to the first main surface, of the inorganic layer structure. In other words, the stack can comprise of more than one main surface opposing each other. In particular, these two opposing main surfaces can be formed as part of a single process step which can also be a unified manufacturing process. This may bring the advantage of a more efficient quality control process when both main surfaces can be inspected after a single process step. On the other hand, the first and second main surfaces can also be opposing with regards to the stacking direction which means that the first and second main surfaces can also be arranged adjacently to each other on the same side of a stack. Preferably the first and second main surfaces are arranged opposed to each other with reference to a stacking direction which can also mean that the first and second main surfaces form a respective interface with a layer structure, for example an electrically insulating and/or an electrically conductive layer structure.

In an embodiment, both, the first portion and the second portion of the stack, each comprises a tapered side wall, in particular wherein each portion of the tapered stack side wall is tapered in an opposed direction. In other words, the stack can be made up of two different portions wherein each portion can comprise a tapered side wall. For example, when viewed in a lateral direction, the tapered side walls of the stack can be an arrow-like shape when both portions each comprising a tapered side wall are tapered in opposing directions with the junction of both portions constituting the largest lateral extent of the side wall. This may bring the advantage of reducing stresses in both opposing directions when referenced to the point of largest lateral extent of the stack.

In an embodiment, the inorganic layer structure comprises at least a lateral extension different from the lateral extensions of both, the first portion and the second portion of the stack, wherein the lateral extensions of the first portion and the second portion of the stack each forms an edge distanced from each other by a portion of the stack sidewall. In particular, the edge of the first portion of the stack that is formed by a portion of the stack sidewall can be different, which is a different lateral extension, from the edge of the second portion of the stack that is formed by a portion of the stack sidewall. Nevertheless, both edges of the first and second portion of the stack can also be of the same lateral extension. This may bring the advantage of a full glass processing with the edge of a respective portion being formed by a portion of the stack sidewall. This may reduce the need to embed an additional material to form the edge.

In an embodiment, the distance between the first portion of the stack and a neighbouring edge of the stack sidewall is different from the distance between the second portion of the stack and a neighbouring edge of the stack sidewall. This may bring the advantage of having two portions having different distances between the respective portion of the stack and the neighbouring edge of the stack sidewall enabling a more differentiated stress properties in each respective portion.

In an embodiment, the inorganic layer structure is configured as a core layer in the stack. In other words, the electrically insulating layer structure and/or the electrically conductive layer structure may be arranged in a peripheral when referenced to the inorganic layer structure. In particular, the inorganic layer structure may be arranged sandwiched between at least a part of an electrically insulating layer structure and/or at least a part of an electrically conductive layer structure. This may bring the advantage of enabling the inorganic layer structure to be structurally shielded in the stacking direction.

The inorganic layer structure as a core can provide a good mechanical stability for the whole component carrier, that means it can compensate the warpage from the thermal treatment on the organic material. Besides that, the flat surface of inorganic layer structure can help forming the fine line structuring and high density for high performance computing.

In an embodiment, the inorganic layer structure comprises at least one of glass, ceramic, a semiconductor material, quartz.

In an embodiment, the inorganic layer structure is formed to be laterally exposed and forms at least partially said stack side wall which is formed by a cutting of the stack. In particular, the cutting of the stack can be a dicing and/or a laser separation of materials. This may bring the advantage of a decrease in the saw street distance and/or a united size tolerance decrease.

In an exemplar embodiment, the invention can mitigate the effects of a glass to dielectric material damage, for example delamination and glass crack. This can result from a maximum stress point change from a glass wall to an Ajinomoto Build-up Film (ABF) or a glass interface. The invention may provide further advantages like reducing and improving glass crack propagation risks due to front and back ABF cure/residual shrinkage stress.

In an embodiment, the singulation of the component carrier and tapered portions with exposed inorganic lateral edge is achieved by the three steps cutting, in particular by the laser ablation. With such kind of approach and structure, the stress point is changed and stress around the whole inorganic layer structure (inside and surface of inorganic layer structure) can be reduced, thus the crack can be avoided. CTE mismatch of different material in the component carrier can be compensated and even the stress from the cutting strength is also deducted significantly. The product quality and manufacturing efficiency is improved. Further, it contributes to the high volume manufacturing of the inorganic component in the market.

In an embodiment, the separation/singulation (of a component carrier preform, panel) comprises a first step of laser drilling followed by a second step of mechanical drilling. For example, the laser can cut part of the inorganic layer structure (glass) by the laser ablation and then mechanical cutting/drilling can be used to finally separate the inorganic material (glass). This may reduce the time of using laser ablation and gain efficiency from a manufacturing point of view.

In an embodiment, the separation/singulation (of a component carrier preform, panel) comprises a first step of laser drilling or another material removing process (for example wet etching or plasma etching) to modify the property/properties of the inorganic material (physical/chemical property). Thereby the brittleness of inorganic material may be changed, so the crack can be avoided and the modification may can make the drilling/cutting more efficient.

In an embodiment, the separation/singulation comprises at least two drilling steps, in particular when forming an hourglass-like shape (see Figure 1). For example, forming the hourglass shape may comprise one more step(s) compared with forming a straight or a tapered shape (see Figures 3 and 4). The further one step (e.g. drilling from above and from below the inorganic layer structure) might reduce stress during cutting.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semicured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga203), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.

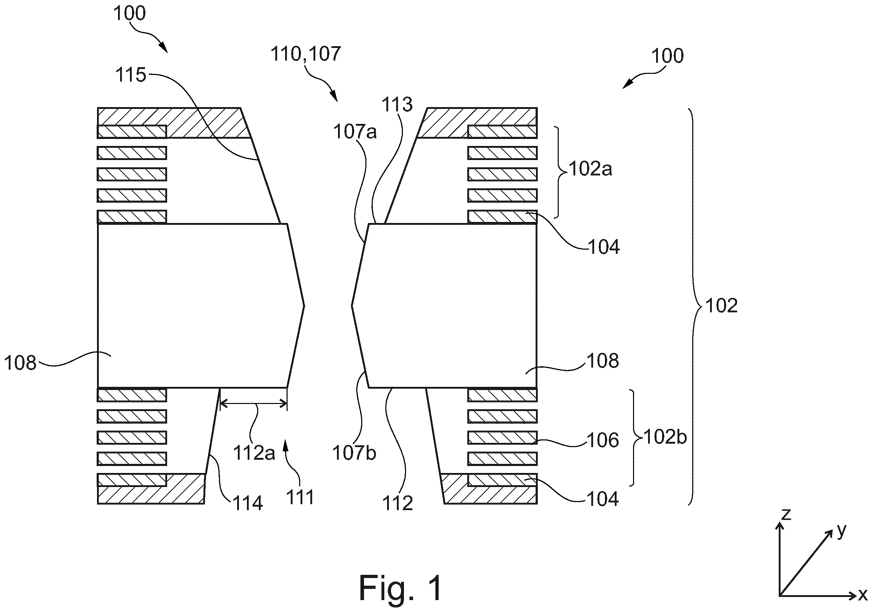

Figure 1 shows a cross-section through two component carriers, according to an exemplary embodiment of the invention.
Figure 2 shows a cross-section through two component carriers, according to the prior-art.
Figures 3a to 3d show a manufacturing process of separating a component carrier preform into component carriers, according to an exemplary embodiment of the invention.

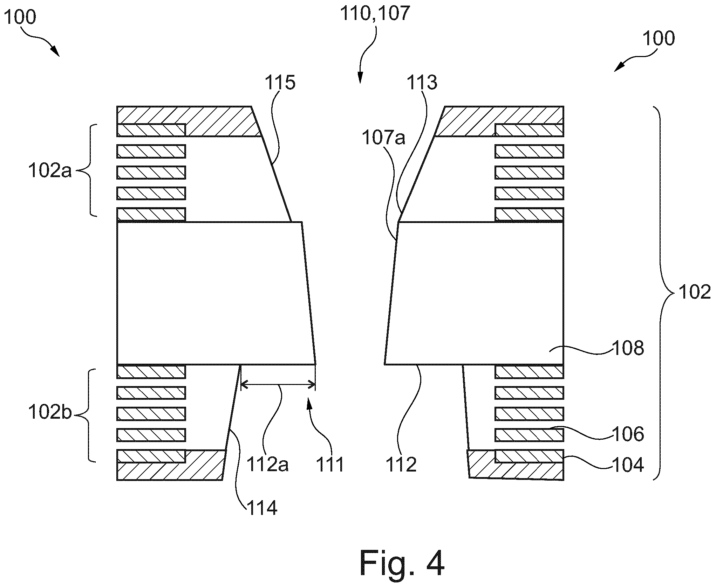

Figure 4 shows a cross-section through component carriers, according to an exemplary embodiment of the invention.

### Detailed Description of the Drawings

**Figure 1** shows a schematic cross-section through two component carrier 100 (after separation), according to an exemplary embodiment of the invention. Each component carrier 100 comprises a stack 102 having electrically insulating layer structures 106 and electrically conductive layer structures 104 provided between said electrically insulating layer structures 106 (layer build-up). The stacking of electrically conductive layer structures 104 are patterned such that they are arranged spaced apart in the stacking direction by electrically insulating layer structures 106. An inorganic layer structure 108 made exemplarily of glass, forms the core layer of the stack 102 and is sandwiched between the layer buildups of electrically insulating layer structures 106 and electrically conductive layer structures 104.

The glass core layer constituting the inorganic layer structure 108 is laterally exposed distal to the arrangement of the electrically conductive layer structures 104 within the stack 102. The laterally exposed surface (here distal to the electrically conductive layer structures 104) can be seen form the stack side walls 107 of the stack 102. The stack side walls 107 can be seen in a lateral direction as tapered with an arrow-like shape with the lateral extension greatest in the middle of the stack 102.

The inorganic layer structure 108 can be seen to be exposed in the lateral direction as mentioned and also exposed in the stacking direction towards both sides perpendicular to the lateral direction. The tapered portion 110 of the stack side walls comprise two portions 107a and 107b arranged adjacently to each other. The part where both portions 107a and 107b constitute the point of the largest lateral extension with the tapering of the stack side walls resulting in a decrease in lateral extensions as both portions 107a and 107b are profiled in opposite directions parallel to the stacking direction. In other words, the surfaces of the sub portions 107a and 107b are tapered away from each other (in opposite directions).

The tapered portion 110 of the inorganic layer structure 108 is formed on the inorganic layer structure 108 and also on the electrically insulating layer structure 106 of the stack 102.

The tapered portion 110 can be seen in Fig. 1 to be defined by one inorganic layer structure 108 and two layer build-up portions (electrically insulating layer structures 106), both arranged adjacent to the inorganic layer structure 108 in the stacking direction.

Both electrically insulating layer structure stacks 106 as seen in Fig. 1, are made, in this example, of Ajinomoto Build-up Film (ABF) in contrast to the glass inorganic layer structure 108 which also serves as a stabilizing core structure. The interface between the electrically insulating layer structures 106 and the inorganic layer structure 108 hence constitutes a high stress point change when cut. The tapering of the electrically insulating layer structures 106 and the glass inorganic layer structure 108 from the cutting method hence mitigates glass substrate horizontal cracks due to the high stress point change and reduction of stress inside and on the surface of the inorganic structure.

The inorganic layer structure 108 has a different lateral extension from the electrically insulating layer structures 106, in the exemplary embodiment of Fig. 1, the inorganic layer structure 108 has a greater lateral extension than both the adjacently arranged electrically insulating layer structure stacks 106. This greater lateral extension of the inorganic layer structure 108 constitutes the formed protrusion as exemplified in Fig. 1.

The formed protrusion forms two steps, one on each side to the sidewards of the protrusion, that is in the stacking direction, at the stack side wall 107. The step is formed at the edge 112 of the inorganic layer structure 108.

The stack side wall 107 has two tapered portions 107a and 107b as seen that are arranged adjacently forming an arrow-like shape when view in a lateral direction. These tapered portions can be seen to be continuously provided along the stack thickness direction and not interrupted by a non-tapered portion. The arrow-like shape of the taper can be attributed to the fact that the tapered portions 107a and 107b are tapered in opposing directions.

In the exemplary embodiment, the stack 102 comprises a first portion 102a and a second portion 102b, both of which are provided on a first and second main surface respectively (in other words, a top layer build-up and a bottom layer build-up). These main surfaces are formed opposing each other in the stacking direction. Both main surfaces can be seen forming an interface between the inorganic layer structure 108, the electrically insulating layer structures 106 and the electrically conductive layer structures 104, with the interface between the inorganic layer structure 108 and the electrically insulating layer structures 106 being arranged proximally to the stack side wall 107 and the interface between the inorganic layer structure 108 and the electrically conductive layer structures 104 arranged distally to the stack side wall 107.

Both, the first and second portions 102a and 102b of the stack 102, each comprises a tapered side wall 107a and 107b as seen in Fig. 1. The tapering is in opposing directions as mentioned above forming the arrow-like shape when viewed in the lateral direction. When viewed in the lateral direction, the tapering can also be seen as taking on an hourglass shape.

The lateral extensions of the first and second portions 102a and 102b of the stack each form an edge 112, 113, which are distanced to each other by a portion of the stack sidewall 107.

The distance between the first portion 102a of the stack 102 and a neighbouring edge 114 of the stack sidewall 107 is also different compared to the distance between the second portion 102b of the stack 102 and a neighbouring edge 115 of the stack sidewall 107. This is especially apparent from Fig. 1 with the former having a larger distance compared to the latter.

In other words, the first portion 102a of the stack 102 extends along the upper main surface of the inorganic layer structure 108 with a first distance, and the second portion 102b of the stack extends along the lower main surface of the inorganic layer structure 108 with a second distance, wherein the first distance is larger than the second distance.

**Figures 3a to 3d** show a component carrier manufacturing process using a laser regarding a cross-section of, according to an exemplary embodiment of the invention.

Fig. 3a exemplifies a component carrier preform (panel), having a top layer build-up portion and a bottom layer build-up portion and a glass core right in the middle of the stack.

Fig. 3b exemplifies a laser manufacturing for a top dielectric material opening with tapered side walls formed at the top electrically insulating layer structure 106. The top dielectric opening has a width of for example approximately 5 to 300 µm. In the subsequent step, Fig. 3c exemplifies a bottom dielectric material opening step also formed by a manufacturing laser. This step now forms the tapered side walls at the bottom dielectric material. The bottom dielectric opening has a width of for example approximately 10 to 500 µm. Now with both, top and bottom dielectric materials, formed with tapered side walls, the subsequent step in Fig. 3d exemplifies a laser cutting of the glass core forming a glass cutting width of for example approximately 1 to 250 µm.

The width from such structure provides a big tolerance and accuracy for different cutting methods, therefore it can choose different cutting method to achieve different accuracy. As the invention exemplifies, the lateral or horizontal cracking of the glass substrate is greatly reduced by reducing the stress to the glass core by the first two laser manufacturing process steps shown in Fig. 3b and 3c. It can be further seen that during the laser cutting, more material at the bottom side is removed than at the top side as the laser heat and energy damage the bottom side due to the transparency of the inorganic layer structure while the laser ablation treats the opposite side. Depending on the desired application, this may provide specific advantages. Finally, two component carriers 100 are obtained from separating the component carrier preform.

**Figure 4** shows a cross-section through two component carriers 100, according to an exemplary embodiment of the invention. In contrast to Fig. 1, Fig. 4 shows only one tapered portion 107a that taper in only one direction. The lateral extension of the inorganic layer structure 108 in Fig. 4 is now the greatest at a lower edge 112 interfacing an lower electrically insulating layer structure 106 of the bottom layer-build-up portion.

### List of numerical references

- 100: Component carrier
- 102: Stack
- 102a, 102b: First and second portions of stack
- 104: Electrically conductive layer structure
- 106: Electrically insulating layer structure
- 107: Side wall
- 107a, b: Sub portions of side wall
- 108: Inorganic layer structure
- 110: Tapered portion of side wall
- 111: Protrusion of inorganic layer structure
- 112, 113: Edge of side wall of inorganic layer structure
- 114, 115: Neighbouring edge of side wall of inorganic layer structure

## Claims

1. A component carrier (100) with a stack (102), wherein said stack (102) comprises:
at least one electrically insulating layer structure (106);
at least one electrically conductive layer structure (104);
a stack side wall (107), wherein at least a portion thereof is tapered with respect to a stacking direction; and
at least one inorganic layer structure (108), said inorganic layer structure (108) being laterally exposed and forming at least partially said stack side wall (107).

2. The component carrier (100) according to claim 1,
wherein the tapered portion (110) of the stack side wall (107) comprises or consists of the exposed portion of the inorganic layer structure (108).

3. The component carrier (100) according to claim 1 or 2,
wherein the tapered portion (110) of the stack side wall (107) comprises two sub portions arranged adjacent to each other,
wherein the surface of each sub portion is tapered,
in particular wherein the surfaces taper away from each other.

4. The component carrier (100) according to one of the preceding claims, wherein the tapered portion (110) of the stack side wall (107) is formed at least partially on at least one of the electrically insulating layer structure (106) and the inorganic layer structure (108) of the stack (102).

5. The component carrier (100) according to one of the preceding claims, wherein the at least one electrically insulating layer structure (106), that defines the tapered portion (110), is different from the at least one inorganic layer structure (108),
in particular wherein said at least one electrically insulating layer structure (106) comprises an organic material.

6. The component carrier (100) according to one of the preceding claims, wherein said inorganic layer structure (108) comprises a lateral extension being different (X, Y) from the electrically insulating layer structure (106) and the electrically conductive layer structure (104) of the stack (102),
wherein said lateral extension forms at least one protrusion (111) at said stack side wall (107)

7. The component carrier (100) according to claim 6,
wherein said protrusion (111) forms at least one step at the edge (112) of said inorganic layer structure (108).

8. The component carrier (100) according to one of the preceding claims, wherein said stack side wall (107) comprises at least two tapered portions (107a, 107b), wherein said tapered portions (107a, 107b) are arranged, in particular adjacently, along a stack thickness direction.

9. The component carrier (100) according to claim 8,
wherein said at least two tapered portions (107a, 107b) are distanced to each other by at least one of the electrically insulating layer structure (106) and the inorganic layer structure (108) of the stack (102).

10. The component carrier (100) according to claim 8 or 9,
wherein said at least two tapered portions (107a, 107b)
taper in the same direction or in opposed directions.

11. The component carrier (100) according to one of the preceding claims, wherein
a first portion (102a) of the stack (102) is provided on a first main surface of the inorganic layer structure (108); and
a second portion (102b) of the of the stack (102) is provided on a second main surface, being opposed to the first main surface, of the inorganic layer structure (108),
in particular wherein both, the first portion (102a) and the second portion (102b) of the stack (102), each comprises a tapered side wall,
more in particular wherein each portion of the tapered stack side wall (107) is tapered in an opposed direction.

12. The component carrier (100) according to claim 11,
wherein said inorganic layer structure (108) comprises at least a lateral extension different from the lateral extensions of both, the first portion (102a) and the second portion (102b) of the stack (102),
wherein the lateral extensions of the first portion (102a) and the second portion (102b) of the stack (102) each forms an edge (112, 113) distanced from each other by a portion of the stack sidewall (107).

13. The component carrier (100) according to claim 12,
wherein the distance (112a) between the first portion (102a) of the stack (102) and a neighbouring edge (114) of the stack sidewall (107) is different from the distance between the second portion (102b) of the stack (102) and a neighbouring edge (115) of the stack sidewall (107).

14. The component carrier (100) according to one of the preceding claims, wherein the inorganic layer structure (108) is configured as a core layer in the stack (102).

15. A method of manufacturing a component carrier (100), wherein the method comprises:
providing a stack (102) with at least one electrically insulating layer structure (106) and at least one electrically conductive layer structure (104);
providing a stack side wall (107) to the stack (102), wherein at least a portion (107a, 107b) thereof is tapered with respect to the stacking direction (Z); and
providing at least one inorganic layer structure (108) to the stack (102),
wherein said inorganic layer structure is formed to be laterally exposed and forms at least partially said stack side wall (107).
